# EUROPÄISCHE PATENTSCHRIFT

(11) **EP 0 688 475 B1**
(45) Veröffentlichungstag und Bekanntmachung des Hinweises auf die Patenterteilung: **16.09.1998**
(21) Anmeldenummer: 94908970.0
(22) Anmeldetag: 11.03.1994
(51) Int. Cl.: H03H 9/02

(54) **MIT AKUSTISCHEN OBERFLÄCHENWELLEN ARBEITENDES BAUELEMENT**
COMPONENT WORKING WITH ACOUSTIC SURFACE WAVES
COMPOSANT FONCTIONNANT AVEC DES ONDES ACOUSTIQUES DE SURFACE

(30) Priorität: 11.03.1993 DE 4307726
(43) Veröffentlichungstag der Anmeldung: 27.12.1995
(73) Patentinhaber: SIEMENS MATSUSHITA COMPONENTS GmbH & CO. KG, 81617 München (DE)
(72) Erfinder: KURP, Stefan, D-80687 München (DE); HARTEL, Christoph, D-81377 München (DE); RUILE, Werner, D-80636 München (DE); REINDL, Leonhard, D-83071 Stephanskirchen (DE); ZIBIS, Peter, D-85635 Höhenkirchen-Siegertsbrunn (DE); MACHUI, Jürgen, D-80809 München (DE)
(74) Vertreter: Epping, Wilhelm, Dr.-Ing.
(86) Internationale Anmeldenummer: DE9400263
(87) Internationale Veröffentlichungsnummer: WO9421040

(56) Entgegenhaltungen:
- GB-A- 2 088 167
- PATENT ABSTRACTS OF JAPAN vol. 16, no. 432 (E-1262) 9. September 1992 & JP,A,04 150 512 (JAPAN RADIO) 25. Mai 1992
- PATENT ABSTRACTS OF JAPAN vol. 15, no. 157 (E-1058) 19. April 1991 & JP,A,03 029 407 (MITSUBISHI) 7. Februar 1991
- PATENT ABSTRACTS OF JAPAN vol. 16, no. 215 (E-1204) 20. Mai 1992 & JP,A,04 035 312 (MURATA) 6. Februar 1992

## Beschreibung

Die vorliegende Erfindung betrifft ein mit akustischen Oberflächenwellen arbeitendes Bauelement nach dem Oberbegriff des Patentanspruchs 1.

Oberflächenwellenfilter, insbesondere Filter mit feinen Strukturen sind empfindlich gegen elektrostatische Entladungen. Kommen derartige Filter in der Praxis mit elektrostatisch geladenen Teilen in Berührung, so können sie durch die Entladung dieser Teile über einen im Filter enthaltenen Interdigitalwandler zerstört werden.

Aus der Veröffentlichung JP 3, 029, 407 ist ein Bauelement gemäß dem Oberbegriff des Anspruchs 1 bekannt.

Bisher ist lediglich versucht worden, die Berührung von Oberflächenwellenfiltern mit elektrostatisch geladenen Teilen in der Fertigung, beim Messen und in Geräten, in denen sie zur Anwendung kommen, so weit wie möglich zu vermeiden.

Da derartige Berührungen in der Praxis jedoch nicht sicher auszuschließen sind, liegt der vorliegenden Erfindung die Aufgabe zugrunde, die Filter selbst so auszugestalten, daß bei ihrer Berührung mit elektrostatisch geladenen Teilen ihre Zerstörung nicht auftreten kann.

Diese Aufgabe wird bei einem mit akustischen Oberflächenwellen arbeitenden Bauelement der eingangs genannten Art erfindungsgemäß durch die Merkmale des kennzeichnenden Teils des Patentanspruchs 1 gelöst.

Weiterbildungen der Erfindung sind Gegenstand von Unteransprüchen.

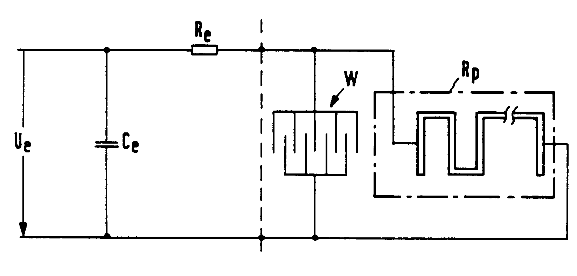

Die Erfindung wird im folgenden anhand eines in der einzigen Figur der Zeichnung dargestellten Ausführungsbeispiels näher erläutert.

Die Figur zeigt ein schematisches Ersatzschaltbild eines erfindungsgemäß ausgebildeten Oberflächenwellenfilters sowie einer durch ein elektrostatisch geladenes Teil gebildeten Spannungsquelle.

Gemäß der Figur der Zeichnung ist auf der rechten Seite einer gestrichelten senkrechten Linie ein Oberflächenwellenfilter dargestellt. Da derartige Oberflächenwellenfilter an sich bekannt sind, ist nur ein Interdigitalwandler W eines derartigen Filters dargestellt.

Diesem Interdigitalwandler W ist erfindungsgemäß ein Widerstand Rₚ parallel geschaltet, über den bei Berührung des Filters mit einem elektrostatisch geladenen Teil Entladungsströme abfließen können und damit das Filter zerstörende elektrische Überschläge vermieden werden.

Eine durch ein elektrostatisch geladenes Teil gegebene externe Spannungsquelle ist in der Figur auf der linken Seite der senkrechten gestrichelten Linie durch eine Ersatzspannungsquelle mit einer externen Spannung Uₑ, einer Eigenkapazität Cₑ und einem Innenwiderstand Rₑ dargestellt.

Für eine optimierte Dimensionierung des Parallelwiderstandes Rₚ sind zwei gegenläufige Bedingungen maßgebend. Zum einen muß der Wert des Parallelwiderstandes Rₚ groß gegen die Impedanz des Interdigitalwandlers W sein, damit die normale Funktion des Bauelementes nicht ins Gewicht fallend gestört wird. Zum anderen darf bei einer Entladung aufgrund einer Berührung mit einem elektrostatisch geladenen Teil das Abfließen der Ladungen über den Parallelwiderstand Rₚ nicht länger dauern als die Entladung der externen Kapazität Cₑ. Wird die Zeitkonstante Rₑ · Cₑ der externen Spannungsquelle mit tₑ und die Zeitkonstante Rₚ · Cᵢ (Cᵢ ist die Eigenkapazität des Interdigitalwandlers W) des mit dem Parallelwiderstand Rₚ versehenen Filters mit tᵢ bezeichnet, so soll in Weiterbildung der Erfindung tₑ groß gegen tᵢ sein.

Der Parallelwiderstand Rₚ wird zweckmäßigerweise auf dem Substrat des Filters als integrierte Widerstandsschicht vorgesehen, welche beispielsweise die Form einer Mäanderlinie besitzen kann, wie dies in der Figur schematisch dargestellt ist.

Für ein Oberflächenwellenfilter in Form eines Bandpassfilters bei 480 MHz für Satellitenempfänger haben Versuche in der Praxis gezeigt, daß gute Ergebnisse mit Werten für den Parallelwiderstand Rₚ im Bereich von 1,5 bis 3kΩ erreicht werden. Beispielsweise für einen Widerstandswert von 3kΩ hat sich eine deutlich verbesserte Grenzspannung von Uₘₐₓ = 150V bei solchen Bandpassfiltern ergeben.

## Patentansprüche

1. Mit akustischen Oberflächenwellen arbeitendes Bauelement, insbesondere Oberflächenwellenfilter mit mindestens einem Interdigitalwandler (W), dem ein Widerstand (Rₚ) parallel geschaltet ist, **dadurch gekennzeichnet**, daß zum Schutz gegen elektrostatische Entladung durch Berührung des Bauelementes mit elektrostatisch geladenen Teilen der Wert des Parallelwiderstandes (Rₚ) derart festgelegt ist, daß die Zeitkonstante (tₑ) aus einem Innenwiderstand (Rₑ) und einer Eigenkapazität (Cₑ) der durch ein elektrostatisch geladenes Teil gebildeten Spannungsquelle groß gegen die Zeitkonstante (tᵢ) aus Parallelwiderstand (Rₚ) und Eigenkapazität (Cᵢ) des Interdigitalwandlers (W) ist.

2. Bauelement nach Anspruch 1, **dadurch gekennzeichnet**, daß als Parallelwiderstand (Rₚ) ein auf einem Substrat des Bauelementes integrierter Widerstand in Form einer Widerstandsschicht vorgesehen ist.

3. Bauelement nach Anspruch 1 und 2, **dadurch gekennzeichnet**, daß die Widerstandsschicht (Rₚ) die Form einer Mäanderlinie besitzt.

## Claims

1. Component working with surface acoustic waves, in particular a surface acoustic wave filter having at least one interdigital converter (W) with a parallel-connected resistor (Rₚ), **characterized in that** for protection against electrostatic discharge resulting from the component being touched by electrostatically charged parts, the value of the parallel resistor (Rₚ) is defined in such a manner that the time constant (tₑ) of an internal resistance (Rₑ) and an intrinsic capacitance (Cₑ) of the voltage source which is formed by an electrostatically charged part is long in comparison with the time constant (tᵢ) of the parallel resistor (Rₚ) and the intrinsic capacitance (Cᵢ) of the interdigital converter (W).

2. Component according to Claim 1, **characterized in that** a resistor is provided as the parallel resistor (Rₚ) which is integrated on a substrate of the component and is in the form of a resistance film.

3. Component according to Claims 1 and 2, **characterized in that** the resistance film (Rₚ) is in the form of a meandering line.

## Revendications

1. Composant fonctionnant par des ondes acoustiques de surface, notamment filtre d'ondes de surface comportant au moins un transducteur (W) interdigité avec lequel une résistance (Rₚ) est montée en parallèle, caractérisé en ce que, pour protéger d'une décharge électrostatique par contact du composant avec des pièces chargées d'électricité statique, la valeur de la résistance (Rₚ) en parallèle est fixée de telle manière que la constante (tₑ) de temps, produit d'une résistance (Rₑ) interne par une capacité (Cₑ) propre de la source de tension formée par une pièce chargée d'électricité statique, est grande par rapport à la constante (tᵢ) de temps, produit de la résistance (Rₚ) en parallèle par la capacité (Cᵢ) propre du transducteur (W) interdigité.

2. Composant suivant la revendication 1, caractérisé en ce qu'il est prévu comme résistance (Rₚ) en parallèle une résistance en forme de couche résistante, intégrée à un substrat du composant.

3. Composant suivant les revendications 1 et 2, caractérisé en ce que la couche (Rₚ) résistante a la forme d'une ligne sinueuse.
